# EUROPÄISCHE PATENTSCHRIFT

(11) **EP 2 286 462 B1**
(45) Veröffentlichungstag und Bekanntmachung des Hinweises auf die Patenterteilung: **06.08.2014**
(21) Anmeldenummer: 09741909.7
(22) Anmeldetag: 11.05.2009
(51) Int. Cl.: H01L 31/02, H01L 31/048, H01R 13/52, H01R 4/72

(54) **ANSCHLUSSDOSE, VERWENDUNGEN EINER ANSCHLUSSDOSE UND VERFAHREN**
CONNECTION BOX, USES OF A CONNECTION BOX AND METHOD
BOÎTE DE JONCTION, UTILISATIONS D'UNE BOÎTE DE JONCTION ET PROCÉDÉ

(30) Priorität: 09.05.2008 DE 102008022908
(43) Veröffentlichungstag der Anmeldung: 23.02.2011
(73) Patentinhaber: Yamaichi Electronics Deutschland GmbH, 85609 Aschheim-Dornach (DE); YAMAICHI ELECTRONICS CO., LTD., Ohta-ku, Tokyo 143-8515 (JP)
(72) Erfinder: QUITER, Michael, D-57482 Wenden (DE)
(74) Vertreter: Müller-Boré & Partner Patentanwälte PartG mbB
(86) Internationale Anmeldenummer: PCT/EP2009/003329
(87) Internationale Veröffentlichungsnummer: WO 2009/135691

(56) Entgegenhaltungen:
- EP-A- 1 729 369
- EP-A- 1 801 889
- WO-A-2007/026465
- DE-U1- 20 311 183
- JP-A- 2004 134 717
- US-A- 5 194 692
- US-A1- 2004 261 835

## Beschreibung

Die Erfindung betrifft eine Anschlußdose, Verwendungen einer Anschlußdose und Verfahren.

Herkömmliche Solarmodule zur Erzeugung elektrischer Energie aus Sonnenlicht als Beispiel einer bevorzugten Leiterplatte umfassen eine oder mehrere einzelne Solarzellen. Je nach gewünschter vom Solarmodul zur Verfügung zu stellenden Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt. Die elektrischen Anschlußelemente der Solarzellengruppen des Solarmoduls werden nach außen geführt. Bei partieller Verringerung der Bestrahlungsintensität durch Sonnenlicht auf einzelne Solarzellen bzw. Solarzellengruppen, beispielsweise durch Verschmutzung oder Schattenwurf, können unter anderem folgende Effekte auftreten:
(1) Eine (gleichmäßige) Verringerung der Bestrahlungsintensität innerhalb der zusammengeschalteten Solarzellengruppen führt zu einer Leistungsverminderung der jeweiligen Solarzellengruppe.
(2) Durch eine partielle Abschattung einer Solarzelle innerhalb einer Solarzellengruppe wirkt diese abgeschattete Solarzelle als Sperrdiode bzw. Widerstand innerhalb des Stromkreises der Solarzellengruppe, was zum einen dazu führen kann, daß die gesamte Solarzellengruppe keine elektrische Energie mehr liefern kann und zum anderen zu einer Beschädigung der abgeschatteten Solarzelle und damit zum dauerhaften Ausfall der Solarzellengruppe führen kann.

In jedem Fall können zwischen den herausgeführten Anschlüssen der Solarzellengruppen eines Solarmoduls, je nach Bestrahlungsintensität auf die einzelnen Solarzellen, unterschiedliche Spannungen anliegen. Eine Reihenschaltung der Solarzellengruppen durch entsprechende Schaltung der nach außen geführten Anschlüsse führt analog zu den oben genannten Problemen.

Um die mit der unterschiedlichen Bestrahlungsintensität der Solarzellen verbundenen Probleme zu vermeiden, werden herkömmlich sogenannte Bypass-Dioden, verwendet, die elektrisch antiparallel zu den Solarzellengruppen geschaltet werden. Diese Bypass-Dioden haben die Wirkung, daß der Stromfluß durch das Solarmodul an Solarzellengruppen, welche eine nur geringe Leistung liefern, vorbei geleitet wird, d.h. die Anschlußelemente dieser Solarzellengruppe eines Solarmoduls werden durch die Bypass-Diode kurz geschlossen und die entsprechende Solarzellengruppe dadurch überbrückt. Somit liefert eine solche Solarzellengruppe zwar keinen Anteil mehr zur Gesamtleistung des Solarmoduls, der Gesamtstromfluß durch das Solarpaneel ist jedoch im wesentlichen ungehindert und eine Beschädigung einzelner Solarzellen wird verhindert.

Solarpaneele, umfassen daher neben dem Solarmodul in der Regel eine elektrische Anschlußdose mit zumindest zwei Kontaktvorrichtungen und zumindest einer Bypass-Diode. Die Solarzellen in einem Solarmodul sind in der Regel durch flache dünne Leiterbänder miteinander verbunden. Diese Leiterbänder werden aus dem Solarmodul als Anschlußelemente heraus geführt, und manuell mit einer in der Anschlußdose angeordneten elektrischen Kontaktvorrichtung kontaktiert. Die Anschlußdose des Solarpaneels weist daher in der Regel auf der dem Solarmodul zugewandten Seite eine Anschlußeinführöffnung auf, durch welche die Leiterbänder hindurch geführt, manuell umgebogen und beispielsweise an Anschlußklemmen angeschlossen werden. Die Anschlußdose wird herkömmlicherweise anschließend mit einem isolierenden Harz ausgegossen, um die Anschlußdose und die Leiterbänder fest miteinander zu verbinden und elektrisch voneinander zu isolieren sowie feuchtigkeitsdicht von der Umgebung abzuschließen. Das mit der Anschlußdose versehene Solarmodul wird als Solarpaneel bezeichnet.

Die Druckschrift EP 1 729 369 A2 offenbart eine Anschlußdose für ein Solarmodul, welche einen elektrischen Folienleiter des Solarmoduls mit zumindest einem Anschlußkabel elektrisch kontaktiert. Die Anschlußdose umfaßt ein Gehäuse, in welchem eine elektrische Kontaktvorrichtung angeordnet ist. Die elektrische Kontaktvorrichtung ist ausgelegt, den elektrischen Folienleiter des Solarmoduls zu kontaktieren. Weiter weist das Gehäuse zumindest eine durchgehende Öffnung auf, durch welche ein Ende des Anschlußkabels hindurchgeführt wird, um das Anschlußkabel im Inneren des Gehäuses mit der Kontaktvorrichtung elektrisch zu kontaktieren. Nach dem Herstellen des elektrischen Kontaktes kann das Gehäuse mittels eines Deckels geschlossen werden.

Die Druckschrift JP 2004-134 717 A offenbart eine Anschlußdose für ein Solarmodul, welche eine flache, plattenähnliche Unterseite und eine Abdeckung aufweist, wobei die elektrisch kontaktierenden Teile zwischen der Unterseite und der Abdeckung der Anschlußdose angeordnet sind. Zum elektrischen Anschluß des Solardmoduls an zwei Anschlußkabel umfaßt die Anschlußdose eine Leiterplatte, welche an der Unterseite der Anschlußdose angebracht ist. Nach dem elektrischen Kontaktieren der Anschlußkabel mit den elektrischen Leitern des Solarmoduls mittels der Leiterplatte, wird die Abdeckung der Anschlußdose auf die Unterseite der Anschlußdose gesetzt. Die Abdeckung der Anschlußdose weist ein Loch auf, durch welches das Innere der durch die Unterseite und die Abdeckung ausgebildeten Anschlußdose mit einem Silikonharzmaterial gefüllt wird.

Die Druckschrift US 5 194 692 B offenbart eine Kabelkupplung, wobei die elektronischen Bauteile durch einen Schrumpfschlauch umhüllt oder durch eine Hülse umgeben sind, die mit einem flüssigen Kunstharz gefüllt werden kann.

Die Druckschrift WO 2007/026 465 A1 offenbart ein witterungsresistentes Solarmodul.

Aufgrund des manuellen Anschließens und des Ausgießens der Anschlußdose mit Harz ist die Montage eines Solarpaneels zeit- und kostenintensiv. Es ist Aufgabe der Erfindung, eine elektrische Anschlußdose, eine Verwendung der Anschlußdose, ein Verfahren zum Herstellen einer Anschlußdose sowie ein Verfahren zum Herstellen eines Solarpaneels bereitzustellen, welche zum einen die elektrischen Kontakte zuverlässig vor Feuchtigkeit schützt und zum anderen eine einfache und kostengünstige Montage ermöglicht.

Die Aufgabe wird durch die unabhängigen Ansprüche gelöst. Bevorzugte Ausführungsformen sind Gegenstand der abhängigen Ansprüche.

### Anschlußdose gemäß einem Aspekt

Ein Aspekt der vorliegenden Erfindung betrifft eine Anschlußdose für eine Leiterplatte, insbesondere für ein Solarmodul, gemäß Anspruch 1.

Vorteilhafterweise weist die Anschlußdose nur eine geringe Anzahl von Einzelteilen auf, so daß sie einfach und kostengünstig herzustellen ist und eine erhöhte Zuverlässigkeit aufweist. Weiterhin vorteilhafterweise wird durch die innige Verbindung der Gehäusevorrichtung der Bereich in dem das zumindest eine Anschlußkabel aus der Anschlußdose herausragt, im wesentlichen feuchtigkeitsdicht gegen Feuchtigkeit der Umgebung der Anschlußdose verschlossen. In anderen Worten kann vorteilhafterweise durch den Kabelein- bzw. ausgang der Anschlußdose im wesentlichen keine Feuchtigkeit in die Anschlußdose eindringen.

Das Leiteranschlußelement kann insbesondere eine Lötstelle, eine Crimpstelle und/oder Kabelbefestigung umfassen, aber auch insbesondere ein Bereich eines flachen Leiters sein.

Weiter bevorzugt kann das Dichtelement ein ring-, schlauch- oder röhrenförmig geformtes Elastomer sein, welches auf den Endbereich des Anschlußkabels geschoben bzw. daran angeordnet wird, so daß der Endbereich von dem Dichtelement umfangen wird. Insbesondere kann das Dichtelement zunächst ein im wesentlichen flüssiges Dichtmaterial sein, welches an den Endbereich des Anschlußkabels appliziert bzw. aufgespritzt ist, während eines Aushärtungs- bzw. Erstarrungsprozeßes geformt wird und danach das Dichtelement ausbildet. Im Laufe des eines Aushärtungs- bzw. Erstarrungsprozeßes kann das Dichtmaterial schrumpfen oder im Volumen konstant bleiben. Insbesondere können neben dem Endbereich des Anschlußkabels auch weitere Bereiche von dem Dichtelement umfangen werden, wie beispielsweise zumindest bereichsweise der elektrische Leiter des Anschlußkabels, die Kontaktvorrichtung und/oder das Leiteranschlußelement.

Unter dem Begriff "umfangen" eines ersten dreidimensionalen Körpers durch einen zweiten dreidimensionalen Körper wird im Sinne dieser Anmeldung verstanden, daß zumindest ein zweidimensionaler ebener Schnitt existiert, so daß in diesem Schnitt in der Schnittfläche des zweiten Körpers eine geschlossene Linie existiert, so daß alle Punkte der Schnittfläche des ersten Körpers mit der Schnittebene innerhalb oder auf der geschlossenen Linie liegen, wobei der geometrischen Schwerpunkt der geschlossenen Linie innerhalb der geschlossenen Linie liegt.

Unter dem Begriff "innige Verbindung" zwischen zwei Körpern wird im Sinne der Anmeldung eine direkte, unmittelbare mechanische Kontaktierung in einem Kontaktbereich bzw. einer Kontaktfläche verstanden. Insbesondere kann die innige Verbindung durch aufschrumpfen eines umfangenden Körpers auf einen anderen umfangenen Körper erfolgen, so daß der umfangende Körper im Kontaktbereich eine Kraft bzw. mechanische Spannung auf den umfangenen Körper ausübt, so daß durch eine elastische bzw. plastische Verformung der beiden Körper im Kontaktbereich im wesentlichen kein Zwischenraum zwischen den beiden Körpern besteht. Insbesondere können die beiden Körper im Kontaktbereich miteinander verschmolzen sein. Dem steht nicht entgegen, daß ein hinreichend kleiner Zwischenraum zwischen den beiden Körpern bestehen kann, vorzugsweise ist der Abstand zwischen den beiden Körpern im Kontaktbereich kleiner als etwa 10µm, besonders bevorzugt kleiner als etwa 5µm und insbesondere kleiner als 2µm.

Unter dem Begriff "feuchtigkeitsdicht" wird im Sinne der vorliegenden Anmeldung eine Dichtheit bzw. eine Barriere gegenüber einem Fluid, insbesondere Wasser oder Wasserdampf verstanden. Feuchtigkeitsdichtheit wird erreicht, wenn die Migration, d.h. das Fließen bzw. Verlagern der Feuchtigkeit aufgrund einer Partialdruckdifferenz bzw. der Druckdifferenz bzw. der Diffusion verhindert bzw. hinreichend verlangsamt wird. Hinreichend langsam kann insbesondere bedeuten, daß die Fließgeschwindigkeit des Fluids in einem Körper innerhalb von Poren oder entlang von kanalförmigen der flächigen präferentiellen Fließwegen vorzugsweise einen Wert von etwa 1 mm pro Jahr, weiter bevorzugt 0,1 mm pro Jahr, insbesondere 0,01 mm pro Jahr nicht überschreitet. Für elektrische Einrichtungen wie die erfindungsgemäße Anschlußdose bedeutet Feuchtigkeitsdichtheit insbesondere, daß die Spezifikationen der Norm IP67 und/oder der Norm IEC 61215, Abschnitt 10.15 erfüllt werden, daß heißt insbesondere daß beim Eintauchen der Anschlußdose in Wasser das Innere der Anschlußdose gegenüber dem Äußeren für mindestens 2 Minuten mit einem Widerstand größer als 400 MΩ elektrisch isoliert wird.

Mit anderen Worten ist ein Kontaktbereich zwischen zwei Körpern, die insbesondere innig miteinander verbunden sind, genau dann feuchtigkeitsdicht, wenn ein Fluid nicht oder nur hinreichend langsam entlang des (flächigen) Kontaktbereichs migrieren kann. D.h. wird zum Beispiel ein erster Körper mit einer Öffnung dadurch verschlossen, daß ein anderer zweiter Körper die Öffnung abschließt, so daß sich die beiden Körper in einem Kontaktbereich mechanisch kontaktieren, insbesondere in einer innigen Verbindung stehen, so ist die Öffnung des Körpers feuchtigkeitsdicht durch den anderen Körper abgeschlossen bzw. ist der Kontaktbereich zwischen den beiden Körpern feuchtigkeitsdicht, wenn entlang des Kontaktbereiches kein Fluid fließt bzw. wenn es hinreichend langsam fließt, so daß das Fluid lediglich in den Kontaktbereich eindringt, diesen jedoch nicht vollständig durchdringt.

Der Begriff "Kontakt" bzw. "kontaktierbar" im Sinne der Anmeldung beinhaltet insbesondere elektrischen und/oder mechanischen Kontakt.

Der Begriff "im wesentlichen" kann eine geringfügige Abweichung von einem Sollwert beschreiben, insbesondere eine Abweichung im Rahmen der Herstellungsgenauigkeit und/oder im Rahmen der notwendigen Genauigkeit, so daß ein Effekt beibehalten wird, wie er bei dem Sollwert vorhanden ist. Der Begriff "im wesentlichen" kann daher eine Abweichung von weniger als etwa 30%, weniger als etwa 20%, weniger als etwa 10%, weniger als etwa 5%, weniger als etwa 2%, bevorzugt weniger als etwa 1 % von einem Sollwert bzw. Sollposition, usw. beinhalten. Der Begriff "im wesentlichen" umfaßt den Begriff "identisch", d.h. ohne Abweichung von einem Sollwert, einer Sollposition usw. sein.

### Bevorzugte Ausführungsformen der Anschlußdose

Vorzugsweise ist das zumindest eine Dichtelement ein flexibles Dichtelement und die Gehäusevorrichtung eine im wesentlichen starre Gehäusevorrichtung. Alternativ ist es auch möglich, daß das Dichtelement und die Gehäusevorrichtung aus im wesentlichen identischen Materialien bestehen bzw. identische Materialien umfassen.

Unter den Begriffen "flexibel" und "starr" werden im Sinne dieser Anmeldung folgende mechanische Materialeigenschaften verstanden, die im wesentlichen durch den Elastizitätsmodul E und Schermodul G quantifiziert werden können. Sowohl ein flexibles als auch ein starres Material können im wesentlichen elastisch als auch plastisch verformbar sein. Unter einer elastischen Verformung wird die geometrische Verformung eines rückstellfähigen Körpers durch eine einwirkende Kraft bzw. mechanische Spannung (Kraft pro Fläche) verstanden, die im wesentlichen vollständig reversibel ist, wenn die Kraft bzw. mechanische Spannung nicht mehr auf den Körper wirkt, so daß der Körper wieder seine ursprüngliche Gestalt annimmt. Ein flexibler Körper zeichnet sich im Gegensatz zu einem relativ dazu starren Körper, oder kurz starren Körper, dadurch aus, daß der Elastizitätsmodul Ef und/oder der Schermodul Gf des flexiblen Körpers, d.h. des flexiblen Dichtelements, kleiner sind als daß der Elastizitätsmodul Es und/oder der Schermodul Gs des starren Körpers, d.h. der starren Gehäusevorrichtung. Mit anderen Worten wird ein flexibler Körper (z.B. das Dichtelement) bei Einwirkung einer gleich großen Kraft bzw. mechanischen Spannung stärker geometrisch verformt als ein starrer Körper (z.B. die Gehäusevorrichtung).

Weiter bevorzugt ist das Verhältnis Es/Ef und/oder Gs/Gf größer als etwa 1,5, besonders bevorzugt größer als etwa 2, oder größer als etwa 5 oder größer als etwa 10, insbesondere größer als etwa 50 oder größer als etwa 100. Bevorzugt ist der Schermodul Gf des flexiblen Dichtelements kleiner als 10⁹ Nm⁻², weiter bevorzugt kleiner als 10⁸ Nm⁻², besonders bevorzugt kleiner als 10⁷ Nm⁻² und insbesondere kleiner als 5×10⁶ Nm⁻². Bevorzugt ist der Schermodul Gs der starren Gehäusevorrichtung größer als 5×10⁶ Nm⁻², weiter bevorzugt größer als 10⁷ Nm⁻² oder größer als 10⁸ Nm⁻², besonders bevorzugt größer als 10⁹ Nm⁻² und insbesondere größer als 5×10⁹ Nm⁻².

Die starre Gehäusevorrichtung kann beispielsweise bereichsweise aus Polyamid, insbesondere Polyamid 66 (PA66) oder glasfaserverstärktem Polyamid, mit einem Elastizitätsmodul von etwa 1 GPa bis etwa 11000 GPa, insbesondere etwa 3 GPa oder etwa 10 GPa bestehen. Die Schmelztemperatur des Materials der Gehäusevorrichtung, insbesondere der Polyamide, kann bei etwa 250°C bis etwa 265°C liegen.

Das flexible Dichtelement besteht vorzugsweise zumindest bereichsweise oder vollständig aus einem thermoplastischen Elastomer (TPE) bzw. einem thermoplastsichen Vulkanisat (TPV) bzw. einem Polyphenylenether (PPE) bzw. einem Gemisch aus Polyphenylenether (PPE) und Polyethylen (PE) mit einem Elastizitätsmodul von etwa 2 MPa bis etwa 10 MPa, insbesondere etwa 3 MPa oder etwa 4 MPa. Weiter bevorzugt besteht das flexible Dichtelement aus einem Polyolefin. Besonders bevorzugt besteht das flexible Dichtelement aus einem α-Vinyl-Copolymer, insbesondere einem Ethylen-Propylen-Copolymer. Der Temperaturbereich in dem die thermoplastischen Elastomere plastisch verformbar sind bzw. schmelzen können liegt vorzugsweise unterhalb der Schmelztemperatur des Materials der Gehäusevorrichtung (d.h. insbesondere von Polyamiden). Insbesondere liegt der Temperaturbereich bei etwa 170°C bis etwa 250°C.

Überraschenderweise resultiert aus der bevorzugten Materialauswahl in vorteilhafter Weise eine Verbindung zwischen der Gehäusevorrichtung und dem Dichtelement, insbesondere zwischen der starren Gehäusevorrichtung und dem flexiblen Dichtelement, die besonders guten Haftungs- und Dichtungseigenschaften aufweist, so daß die gesamte Anschlußdose verbesserte Dichtungseigenschaften gegen Feuchtigkeit bzw. Wasserdampf aufweist und das Innere der Anschlußdose besonders gut gegen schädliche Umwelteinflüsse geschützt ist. Insbesondere ist durch die bevorzugte Materialauswahl vorteilhafterweise die innige Verbindung zwischen der starren Gehäusevorrichtung und dem flexiblen Dichtelement erreichbar, so daß der Kontaktbereich im wesentlichen feuchtigkeitsdicht ist.

Vorzugsweise umfaßt die Anschlußdose zumindest zwei Kontaktvorrichtungen mit jeweils einem Kurzschlußbereich, wobei die Kurzschlußbereiche der Kontaktvorrichtungen mittels zumindest einer Bypass-Diode elektrisch verbunden sind.

Weiter vorzugsweise sind die Kurzschlußbereiche und/oder die zumindest eine Bypass-Diode der Kontaktvorrichtungen zumindest bereichsweise durch das Dichtelement umschlossen, vorzugsweise feuchtigkeitsdicht umschlossen.

Vorteilhafterweise wird dadurch eine doppelte Dichtung der Bypass-Diode erreicht, zum einen durch den Einschluß in das Dichtelement und zum anderen durch die Gehäusevorrichtung.

Weiter vorzugsweise umfaßt die Anschlußdose zumindest zwei Anschlußkabel.

Vorzugsweise ist das Dichtelement im wesentlichen flüssig auf das Anschlußkabel, das Leiteranschlußelement, den Kurzschlußbereich und/oder die Bypass-Diode aufgetragen und insbesondere ist eine innige Verbindung mit diesen durch Abkühlen und/oder Aushärten des Dichtelements erzeugt.

Vorzugsweise ist das flexible Dichtelement zumindest teilweise mit dem Isoliermantel des Anschlußkabels verschmolzen.

Vorzugsweise ragt der mit dem Isoliermantel des Anschlußkabels verschmolzene Bereich des Dichtelements zumindest bereichsweise von der Gehäusevorrichtung hervor, so daß das Dichtelement eine Knickschutztülle des Anschlußkabels ausbildet.

Vorteilhafterweise wird dadurch ein Knicken des elektrischen Leiters des Anschlußkabels vermieden, da durch das, vorzugsweise flexible und nachgiebige, Dichtelement ein minimaler Biegeradius des Anschlußkabels nicht unterschritten wird, wodurch die Ausfallwahrscheinlichkeit des mit der Anschlußdose versehenen Solarpaneels verringert wird. Weiterhin vorteilhafterweise wird die Anschlußdose vor Beschädigung bei einer Bewegung, insbesondere bei einer Knickbewegung geschützt. Insbesondere das Dichtelement in der Ausführungsform als flexibles Dichtelement kann dieser Bewegung folgen bzw. diese Bewegung ausgleichen. Insbesondere bleibt der Kontaktbereich zwischen Dichtelement und dem Kabel im wesentlichen vollständig erhalten und in jedem Fall bleibt das Dichtelement im wesentlichen feuchtigkeitsdicht mit dem Anschlußkabel verbunden.

Vorzugsweise ist die Gehäusevorrichtung im wesentlichen flüssig zumindest bereichsweise auf das Dichtelement und zumindest bereichsweise auf die Kontaktvorrichtung aufgetragen. Besonders bevorzugt ist die Gehäusevorrichtung im wesentlichen flüssig auf das Dichtelement vollständig und/oder auf die Kontaktvorrichtung vollständig aufgetragen Insbesondere ist durch das Auftragen eine innige Verbindung der Gehäusevorrichtung mit dem Dichtelement und der Kontaktvorrichtung durch Abkühlen und/oder Aushärten der Gehäusevorrichtung erzeugt.

Vorzugsweise ist die Gehäusevorrichtung einstückig. Hierbei kann die Gehäusevorrichtung in einem Prozeßschritt gespritzt und/oder gegossen sein.

Vorzugsweise ist die Gehäusevorrichtung zumindest teilweise mit dem Dichtelement verschmolzen.

Vorzugsweise besteht die Gehäusevorrichtung aus einem Material, das stärker schrumpfbar ist, als das Material des Dichtelements.

Der Begriff "schrumpfbar", wie er in dieser Anmeldung verwendet wird, beschreibt eine Volumenänderung, insbesondere eine Volumenreduzierung um zwischen etwa 0,1% und etwa 5%, bevorzugt zwischen etwa 0,2% und etwa 2%, besonderes bevorzugt zwischen etwa 0,3% und etwa 0,7%.

Vorzugsweise ist das zumindest eine Fixierelement an dem zumindest einen Gehäusedeckel angeordnet. Besonders bevorzugt ist das Fixiermittel mit dem Gehäusedeckel verbunden, d.h. geklebt, geklemmt, verschweißt, eingeschmolzen usw. Insbesondere sind das zumindest eine Fixierelement und der zumindest eine Gehäusedeckel einstückig ausgebildet. Hierbei können das Fixierelement und der Gehäusedeckel in einem Prozeßschritt gespritzt und/oder gegossen sein.

Vorzugsweise weist der zumindest eine Gehäusedeckel zumindest ein Verriegelungselement auf.

Vorzugsweise umfaßt der zumindest eine Gehäusedeckel ein Gehäusedeckeldichtelement. Weiter bevorzugt kann das Gehäusedeckeldichtelement ein O-Ring sein, welcher insbesondere in einer Nut des Gehäusedeckels gehalten wird. Es ist auch möglich, daß ein im wesentlichen flüssiges Dichtungsmaterial bereichsweise an den Gehäusedeckel appliziert, wobei nach dem Aushärten bzw. Erstarren des Dichtungsmaterials das Gehäusedeckeldichtelement ausgebildet bzw. geformt ist.

Vorzugsweise besteht das zumindest eine Fixierelement aus Kunststoff oder Metall.

### Verwendung gemäß einem Aspekt

Ein Aspekt der vorliegenden Erfindung betrifft die Verwendung einer erfindungsgemäßen Anschlußdose und eines Solarmoduls als bevorzugte Leiterplatte zum Bereitstellen eines Solarpaneels, wobei die Anschlußdose an dem Solarmodul angeordnet wird, insbesondere an das Solarmodul geklebt wird.

### Verwendung gemäß einem Aspekt

Ein weiterer Aspekt der vorliegenden Erfindung betrifft die Verwendung einer erfindungsgemäßen Anschlußdose zum Verbinden eines Solarmoduls mit einem Leistungsabnehmer, wobei die elektrische Verbindung des Leistungsabnehmers mit dem Solarmodul über die zumindest eine Kontaktvorrichtung der Anschlußdose erfolgt.

### Verfahren gemäß einem Aspekt

Ein Aspekt der vorliegenden Erfindung betrifft ein Verfahren zum Herstellen einer Anschlußdose für eine Leiterplatte, insbesondere ein Solarmodul, mit den Schritten:
- Bereitstellen zumindest einer Kontaktvorrichtung, wobei jede Kontaktvorrichtung ein Kontaktelement und ein Leiteranschlußelement umfaßt,
- Kontaktieren zumindest eines Anschlußkabels mit dem Leiteranschlußelement der zumindest einen Kontaktvorrichtung,
- Anordnen eines Dichtelements, so daß der Endbereich des Anschlußkabels von dem Dichtelement umfangen wird,
- Ausbilden einer Gehäusevorrichtung umfassend eine Aufnahmevorrichtung, so daß das Dichtelement und die Kontaktvorrichtung zumindest bereichsweise von der Gehäusevorrichtung umfangen werden,
- Schrumpfen der Gehäusevorrichtung derart, daß durch Schrumpfen der Gehäusevorrichtung eine innige Verbindung mit dem zumindest einen Dichtelement und/oder der zumindest einen Kontaktvorrichtung erzeugt wird, so daß eine im wesentlichen feuchtigkeitsdichte Verbindung der Gehäusevorrichtung mit dem Dichtelement und/oder der zumindest einen Kontaktvorrichtung erzeugt wird.

### Bevorzugte Ausführungsvarianten des Verfahrens

Vorzugsweise ist das zumindest eine Dichtelement ein flexibles Dichtelement und die Gehäusevorrichtung eine im wesentlichen starre Gehäusevorrichtung.

Vorzugsweise umfaßt das Verfahren zum Herstellen der Anschlußdose die weiteren Schritte:
- Anordnen zumindest einer Bypass-Diode an der zumindest einen Kontaktvorrichtung;
- Anordnen eines Dichtelements, so daß die zumindest eine Bypass-Diode von dem Dichtelement umfangen wird.

Vorteilhafterweise wird dadurch die Bypass-Diode durch das Dichtelement feuchtigkeitsdicht eingeschlossen.

Vorzugsweise werden zumindest zwei Kontaktvorrichtungen bereitgestellt und die zumindest zwei Kontaktvorrichtungen werden mittels der Bypass-Diode mechanisch und/oder elektrisch miteinander verbunden.
Vorzugsweise sind die zumindest zwei Kontaktvorrichtungen vor dem Anordnen der zumindest einen Bypass-Diode einteilig ausgebildet, wobei die einzelnen Kontaktvorrichtungen nach dem Anordnen der Bypass-Diode durch Vereinzelung hergestellt werden.

Vorzugsweise wird die Kontaktvorrichtung bzw. ein Kurzschlußbereich der Kontaktvorrichtung vor dem Verbinden mit zumindest einer Bypass-Diode als einteiliges Stück bereitgestellt. Nach dem Verbinden der Bypass-Diode mit der Kontaktvorrichtung bzw. dem Kurzschlußbereich der Kontaktvorrichtung wird die Verbindung der Kontaktelemente der Kontaktvorrichtung unterbrochen bzw. werden die Kontaktelemente voneinander getrennt. Das Unterbrechen bzw. Trennen erfolgt vorzugsweise an einer Sollbruchstelle der Kontaktvorrichtung. Alternativ kann die Verbindung zwischen den Kontaktelementen der Kontaktvorrichtung nach der Ausbildung des Dichtelementes bzw. der Ausbildung der Gehäusevorrichtung unterbrochen werden. Vorzugsweise ist die Sollbruchstelle in diesem Fall nicht von dem Dichtelement umfaßt. Die Kontaktelemente werden nach dem Trennen bzw. nach dem Unterbrechen mittels der Bypass-Diode elektrisch und mechanisch verbunden.

Mit anderen Worten liegt die Kontaktvorrichtung nach der Herstellung der Anschlußdose zumindest zweiteilig vor, wobei die zumindest zwei Teile mittels zumindest einer Bypass-Diode elektrisch, vorzugsweise auch mechanisch verbunden sind. Insbesondere werden die Kurzschlußbereiche mittels der Bypass-Diode elektrisch und mechanisch verbunden. Nach dem Trennen umfaßt die Kontaktvorrichtung somit zwei Kurzschlußbereiche, zwei Kontaktelemente und zwei Leiteranschlußelemente, die gegenseitig mittels der Bypass-Diode verbunden sind.

Vorzugsweise wird das Dichtelement im wesentlichen flüssig aufgetragen wird, wobei das Verfahren den weiteren Schritt umfaßt: Abkühlen und/oder Aushärten des Dichtelements.

Weiter vorzugsweise kann durch das Abkühlen und/oder Aushärten des Dichtelements das Dichtelement schrumpfen und eine innige Verbindung mit dem Endbereich des zumindest einen Anschlußkabels und/oder der zumindest einen Kontaktvorrichtung erzeugen. Insbesondere kann somit eine feuchtigkeitsdichte Verbindung zwischen dem Dichtelement und dem Endbereich des Kabels hergestellt werden.

Vorzugsweise umfaßt das Verfahren den Schritt: Bereitstellen zumindest eines Gehäusedeckels, welcher ausgelegt ist, eine Öffnung der Aufnahmevorrichtung feuchtigkeitsdicht zu verschließen.

Bereitstellen des Gehäusedeckels beinhaltet insbesondere Anordnen des Gehäusedeckels an der Öffnung der Aufnahmevorrichtung besonders bevorzugt feuchtigkeitsdichtes Anordnen des Gehäusedeckels an der Öffnung der Aufnahmevorrichtung.

Das Ausbilden der Gehäusevorrichtung beinhaltet, daß ein Material der Gehäusevorrichtung im wesentlichen flüssig an bzw. um das Dichtelement, den Endbereich des Anschlußkabels und die Kontaktvorrichtung angeordnet wird bzw. darauf abgelagert, insbesondere gespritzt wird.

### Verfahren gemäß einem Aspekt

Ein weiterer Aspekt der vorliegenden Erfindung betrifft ein Verfahren zum Herstellen eines Solarpaneels mit den Schritten:
- Bereitstellen einer erfindungsgemäßen Anschlußdose;
- Aktivieren eines Haftmittels und/oder Dichtmittels an der Anschlußdose und/oder an der Leiterplatte
- Anordnen der Anschlußdose an einer Fläche der Leiterplatte derart, daß zumindest ein elektrisches Anschlußelement der Leiterplatte durch eine Anschlußeinführöffnung in die Aufnahmeeinrichtung eingeführt wird und daß die leiterplattenseitige Öffnung im wesentlichen feuchtigkeitsdicht verschlossen ist,
- Anordnen zumindest eines Fixiermittels, so daß das Kontaktelement an dem zumindest einen elektrischen Anschlußelement der Leiterplatte fixiert ist.
- Anordnen eines Gehäusedeckels an der Anschlußdose derart, daß eine Montageöffnung der Aufnahmeeinrichtung mittels des Gehäusedeckels im wesentlichen feuchtigkeitsdicht verschlossen ist.

### Bevorzugte Ausführungsvarianten des Verfahrens

Vorzugsweise wird das zumindest eine elektrische Anschlußelement der Leiterplatte im wesentlichen kraftfrei in die Aufnahmeeinrichtung eingeführt. D.h. das elektrische Anschlußelement muß während des Einführens keinen mechanischen Widerstand überwinden, z.B. Reibung an der Aufnahmeeinrichtung, so daß keine mechanische Belastung oder Verformung an dem elektrischen Anschlußelement erfolgt.

Vorzugsweise erfolgt die Fixierung des Kontaktelements an dem zumindest einen elektrischen Anschlußelement der Leiterplatte durch das Schließen des Gehäusedeckels mittels zumindest eines an dem Gehäusedeckel angeordneten Fixiermittels. Gegebenenfalls kann auch die elektrische Kontaktierung zwischen dem elektrischen Anschlußelement der Leiterplatte und dem Kontaktelement mittels des Fixiermittels erfolgen.

Vorzugsweise kann die zumindest eine Kontaktvorrichtung das Kontaktelement beim Anordnen der Anschlußdose kontaktieren. Weiterhin vorzugsweise das Anordnen des Fixiermittels und das Anordnen des Gehäusedeckels in einem Schritt erfolgen, und zwar insbesondere dann, wenn das Fixiermittel und der Gehäusedeckel beim Anordnen miteinander verbunden sind.

Die Erfindung ist nicht auf die oben beschriebenen Aspekte bzw. Ausführungsformen bzw. Ausführungsvarianten beschränkt. Vielmehr können einzelne Merkmale der Aspekte und/oder Ausführungsformen und/oder Ausführungsvarianten losgelöst von dem entsprechenden Aspekt bzw. der entsprechenden Ausführungsform bzw. der entsprechenden Ausführungsvariante beliebig miteinander kombiniert werden und insbesondere somit neue Ausführungsformen bzw. Ausführungsvarianten gebildet werden. In anderen Worten gelten die obigen Ausführungen zu den einzelnen Merkmalen der Anschlußdose sinngemäß auch für den die Verwendung(en) sowie die Verfahren und umgekehrt.

### Figurenbeschreibung

Nachfolgend werden bevorzugte Ausführungsformen der vorliegenden Erfindung anhand der beigefügten Zeichnungen beispielhaft erläutert, wobei einzelne Merkmale losgelöst voneinander beliebig zu neuen Ausführungsformen kombiniert werden können. Es zeigt
- Figur 1:: eine Explosionsansicht eines Solarpaneels mit einer Anschlußdose;
- Figur 2:: eine weitere Explosionsansicht des Solarpaneels,
- Figur 3:: eine Perspektivansicht des Gehäusedeckels, und
- Figur 4:: eine Schnittansicht eines Solarpaneels mit einer Anschlußdose.

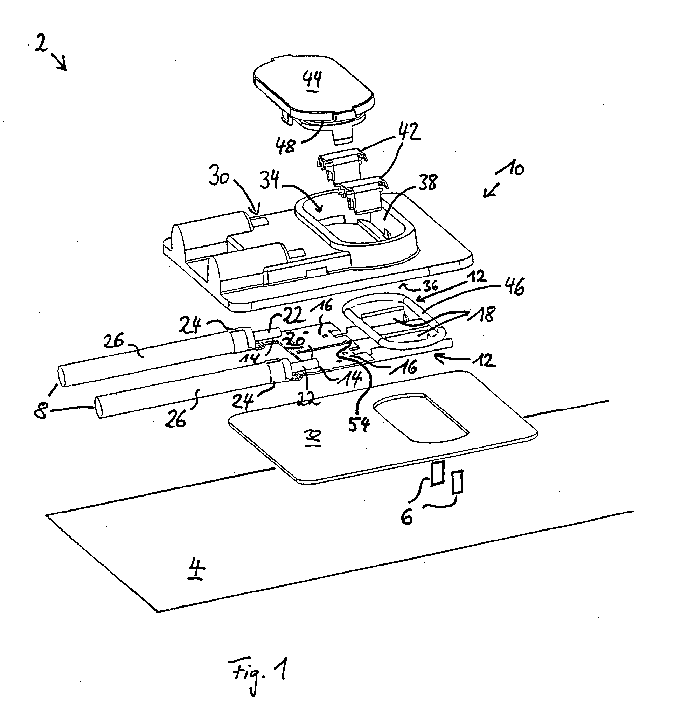

**Figur 1** zeigt eine Explosionsansicht eines Solarpaneels 2. Das Solarpaneel 2 umfaßt ein plattenförmiges Solarmodul 4 als Stromquelle mit zwei Anschlußelementen 6 zwischen denen eine Spannung anliegt, wenn das Solarmodul 4 beleuchtet wird. Um die elektrische Leistung aus dem Solarmodul 4 abzuleiten, werden zwei Anschlußkabel 8 mittels einer an dem Solarmodul angeordneten Anschlußdose 10 mit den zwei Anschlußelementen 6 elektrisch verbunden.

Die Anschlußdose 10 erfüllt dabei die Aufgabe, zum einen elektrische Bauteile aufzunehmen, welche die zwei Anschlußelemente 6 des Solarmoduls 4 überbrücken, wenn das Solarmodul nicht beleuchtet wird und daher als ohmscher Widerstand wirkt und zum anderen die elektrische Kontaktierung der Anschlußelemente 6 mit den Anschlußkabeln 8 sowie die elektrischen Bauteile vor mechanischen und chemischen Einwirkungen, wie beispielsweise Gewalteinwirkung und Korrosion, zu schützen. Vorteilhafterweise wird dies dadurch erreicht, daß die Anschlußdose 10 mechanisch stabil und feuchtigkeitsdicht ausgeführt ist.

Die Kontaktierung eines Anschlußelementes 6 mit einem dazugehörigen Anschlußkabel 8 erfolgt über eine Kontaktvorrichtung 12. Die Kontaktvorrichtung 12 umfaßt ein Leiteranschlußelement 14, einen Kurzschlußbereich 16 und ein Kontaktelement 18. Dabei ist der Kurzschlußbereich 16 vorzugsweise vor der Endmontage einteilig, wobei die Vereinzelung der Kontaktvorrichtungen 12, d.h. der Kontakte der Kontaktvorrichtungen 12 nach der Endmontage erfolgt, vorzugsweise an der Sollbruchstelle 54. In Figur 1 sind zwei Kontaktelemente 18 sowie zwei Leiteranschlußelemente 14 gezeigt, wobei jeweils ein Kontaktelement 18 mit einem Leiteranschlußelement 18 verbunden ist. Das Leiteranschlußelement 14 weist in der gezeigten Ausführungsform eine Lötstelle 20 auf, an welcher ein elektrischer Leiter 22 des Anschlußkabels 8 mechanisch verbunden, d.h. festgelötet ist, um den elektrischen Kontakt zwischen dem Anschlußkabel 8 und der Kontaktvorrichtung 12 herzustellen. Dies gilt sinngemäß für beide Kabel 8, sowie für beide Leiter 22. Alternativ oder zusätzlich könnte der elektrische Kontakt auch durch Klemmen, Crimpen, oder ähnliches hergestellt werden. Ferner weist jedes Leiteranschlußelement 14 vorzugsweise eine Anschlußkabelbefestigungseinrichtung 24 auf, welche den Isolationsmantel 26 des entsprechenden Anschlußkabels 8 festlegt, um eine mechanische Belastung der Verbindung zwischen dem elektrischen Leiter 22 und dem Leiteranschlußelement 14, insbesondere durch Zugkräfte, zu verhindern. In dieser Ausführungsform wird jeder Isolationsmantel 26 durch zwei Metallstreifen 24 als bevorzugte Anschlußkabelbefestigungseinrichtung 24 an dem Leiteranschlußelement befestigt.

Der Kurzschlußbereich 16 stellt einen elektrischen Kontakt zu weiteren, in Figur 1 nicht dargestellten, elektrischen Bauteilen her, welche einen Kurzschluß bzw. eine Überbrückung zwischen den zwei Kontaktvorrichtungen 12 herstellen, wenn das Solarmodul 4 nicht oder unzureichend beleuchtet wird. Dies Überbrückung kann zum Beispiel mittels einer Halbleiterdiode (nicht gezeigt) erfolgen. Die Halbleiterdiode kann auch als Bypass-Diode bezeichnet werden.

Jedes Kontaktelement 18 kontaktiert ein elektrisches Anschlußelement 6, wenn die Anschlußdose 10 an dem Solarmodul 4 montiert ist und sich die Anschlußdose 10 bzw. das Solarpaneel 2 im betriebsfähigen Zustand befindet.

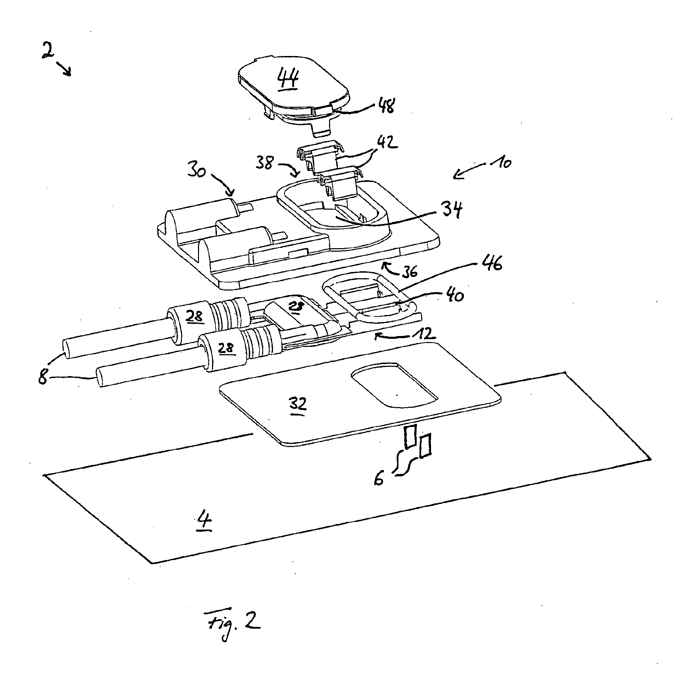

Wie in **Figur 2** gezeigt ist, umfängt ein vorzugsweise flexibles Dichtelement 28 zumindest einen Endbereich eines jeden Anschlußkabels 8. Jedes flexible Dichtelement 28 kann insbesondere durch Spritzgießen an dem Endbereich des entsprechenden Anschlußkabels 8 geformt werden. Alternativ kann auch ein separates flexibles Dichtelement 28, beispielsweise durch Aufstecken, an den Endbereich des entsprechenden Anschlußkabels 8 umfangend angeordnet werden. Ein flexibles Dichtelement 28 kann vorteilhafterweise durch Anlegen einer äußeren Kraft oder eines äußeren Drucks eine mechanische Spannung im Kontaktbereich zwischen dem Isolationsmantel 26 des Anschlußkabels 8 und dem flexiblen Dichtelement 28 erzeugen. Dadurch werden das flexible Dichtelement 28 und das entsprechende Anschlußkabel 8 bzw. dessen Isoliermantel 26 aneinander gepreßt, so daß im wesentlichen kein Zwischenraum zwischen dem Isolationsmantel 26 und dem flexiblen Dichtelement 28 vorhanden ist, in den bzw. durch den Feuchtigkeit migrieren kann. Somit, d.h. aufgrund des Spritzgießens des Dichtelements 28 an dem Isoliermantel 26 des entsprechenden Kabels 8 oder durch Anlegen der äußeren Kraft bzw. des äußeren Drucks wird eine feuchtigkeitsdichte Verbindung zwischen dem flexiblen Dichtelement 28 und dem Isoliermantel 26 des entsprechenden Kabels 8 hergestellt.

Die Kontaktvorrichtung 12 und das, vorzugsweise flexible, Dichtelement 28 jeweils bereichsweise umfangend ist eine, insbesondere im wesentlichen starre, Gehäusevorrichtung 30 ausgebildet, beispielsweise durch Formen der Gehäusevorrichtung 30 in einer Spritzgußform, in welche die Kontaktvorrichtung 12 und das daran angeordnete flexible Dichtelement 28 eingebracht ist. Es versteht sich, daß das Dichtelement nicht notwendigerweise flexibler sein muß, als die Gehäusevorrichtung. Dichtelement und Gehäusevorrichtung können gleich flexibel bzw. starr sein oder das Dichtelement gegebenenfalls starrer sein als die Gehäusevorrichtung.

In der gezeigten bevorzugten Ausführungsform weist die starre Gehäusevorrichtung 30 eine im wesentlichen ebene Seite auf, die ausgelegt ist mittels eines ebenen Haftmittels 32 an der Leiterplatte 4 feuchtigkeitsdicht angeordnet zu werden. Dieses Haftmittel kann beispielsweise ein doppelseitig klebendes Band sein. Ferner weist die starre Gehäusevorrichtung 30 eine Aufnahmeeinrichtung 34 mit zumindest zwei Öffnungen, nämlich einer leiterplattenseitigen Öffnung bzw. Anschlußeinführöffnung 36 und einer leiterplattenabseitigen Öffnung bzw. Montageöffnung 38, auf. Dabei ist das Kontaktelement 18 in der Aufnahmeeinrichtung 34 angeordnet, so daß es in der Aufnahmeeinrichtung 34 durch eines der elektrischen Anschlußelemente 6 der Leiterplatte 4 kontaktierbar ist.

Zum Kontaktieren wird ein elektrisches Anschlußelement 6 durch die Anschlußeinführöffnung 36 in die Aufnahmeeinrichtung 34 eingeführt. Vorzugsweise weist das Kontaktelement 18 einen Kontaktelementrücken 40 auf, so daß das eingeführte elektrische Anschlußelement 6 in einem Endbereich an diesem Kontaktelementrücken 40 umgebogen werden kann, insbesondere um etwa 180 Grad. Ein Fixierelement 42 ist ausgelegt an dem Kontaktelement 18 angeordnet zu werden bzw. darauf aufgeschoben zu werden, so daß das (am Kontaktelementrücken 40 umgebogene) elektrische Anschlußelement 6 an dem Kontaktelement 18 der Kontaktvorrichtung 12 fixiert und elektrisch kontaktiert ist.

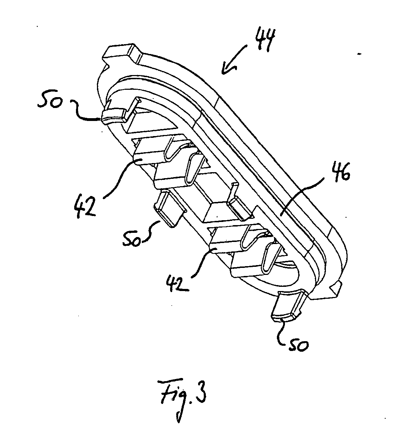

Die Montageöffnung 38 ist durch einen Gehäusedeckel 44, im Detail in **Figur 3** gezeigt, im wesentlichen feuchtigkeitsdicht verschließbar. Um die Feuchtigkeitsdichtheit zu erhöhen weist der Gehäusedeckel 44 ein Gehäusedeckeldichtelement 46 auf, welches vorzugsweise in einer Nut 48 des Gehäusedeckels 44 angeordnet ist. Um den Gehäusedeckel 44 nach dem schließen zu fixieren, umfaßt der Gehäusedeckel 44 zumindest ein Verriegelungselement 50. Insbesondere kann das Verriegelungselement 50 durch das Schließen des Gehäusedeckels 44 derart mit der Aufnahmeeinrichtung 34 verriegelt werden, daß die Verriegelung ohne zumindest teilweisem Zerstören des Gehäusedeckels 44 und/oder der Gehäusevorrichtung 30 unlösbar ist.

An dem Gehäusedeckel 44 ist lösbar oder unlösbar zumindest ein Fixierelement 42 angeordnet. Die Anordnung kann durch verkleben, verschmelzen, verschrauben, vergießen, stecken, klemmen oder ähnliches erfolgen. Insbesondere kann das zumindest eine Fixierelement 42 mit dem Gehäusedeckel 44 einstückig ausgebildet sein. Vorzugsweise bestehen dann das Fixierelement 42 und der Gehäusedeckel 44 aus Kunststoff.

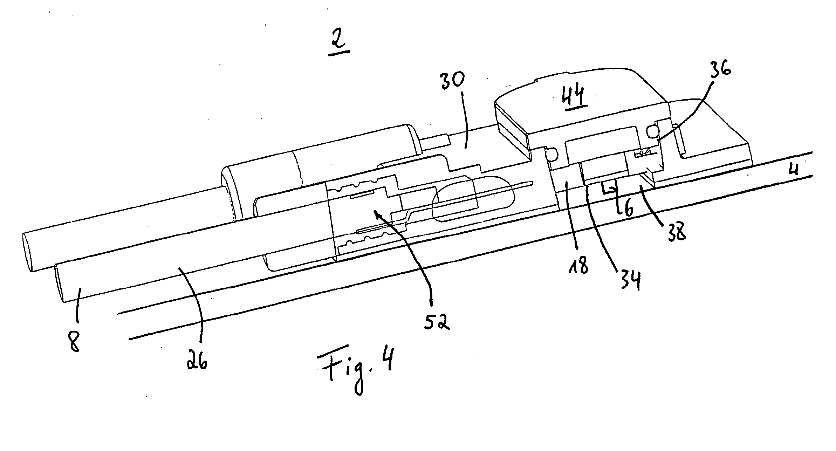

**Figur 4** zeigt eine Schnittansicht einer Anschlußdose 10 an einer Leiterplatte 4, wobei in Figur 4 die Aufnahmeeinrichtung 34 verschlossen ist. Insbesondere ist die leiterplattenseitige Öffnung 36 mittels der Leiterplatte 4 feuchtigkeitsdicht verschlossen, so daß durch die leiterplattenseitige Öffnung 36 keine Feuchtigkeit, insbesondere keine Flüssigkeit durch die leiterplattenseitige Öffnung 36 in die Aufnahmeeinrichtung 34 eindringen kann.

Ebenso ist die Montageöffnung 38 mittels des Gehäusedeckels insbesondere mittels des O-Rings 46 feuchtigkeitsdicht verschlossen, so daß im wesentlichen keine Feuchtigkeit, insbesondere keine Flüssigkeit durch die Montageöffnung 38 in die Aufnahmeeinrichtung 34 eindringen kann. Somit sind die Kontaktelemente 18 und die elektrischen Anschlußelemente 6 im wesentlichen vor Feuchtigkeit geschützt. Ferner sind der Isoliermantel 26 eines jeden Kabels 8 feuchtigkeitsdicht mit dem entsprechenden flexiblen Dichtelement 28 verbunden und jedes flexible Dichtelement 28 feuchtigkeitsdicht mit der Gehäusevorrichtung 30. Somit kann insbesondere durch Kabeldurchführöffnungen 52 in der Gehäusevorrichtung 30 im wesentlichen keine Feuchtigkeit, insbesondere keine Flüssigkeit in das Innere der Anschlußdose 2 eindringen. Da die Gehäusevorrichtung 30 vorzugsweise keine weiteren Öffnungen aufweist, ist das Innere der Gehäusevorrichtung 30 somit im wesentlichen feuchtigkeitsdicht von der Umgebung abgeschlossen.

Die vorliegende Erfindung ist nicht auch die obigen, beispielhaft beschriebenen Ausführungsformen beschränkt. Vielmehr können einzelne Elemente und/oder Merkmale eines jeden beschriebenen Aspekts und/oder einer jeden beschriebenen Ausführungsform mit einzelnen Elementen und/oder Merkmalen der weiteren Aspekte und/oder weiteren Ausführungsformen in beliebiger Weise miteinander kombiniert werden und somit weitere Aspekte und/oder Ausführungsformen gebildet werden. Beispielsweise sind in den Figuren zwei elektrische Anschlußkabel 8 mit jeweils einem Leiter 22 gezeigt. Es können auch mehrere elektrische Anschlußkabel, beispielsweise 4, 6, 8, usw. durch eine entsprechende Anzahl von Kabeldurchführöffnungen 52 in die Anschlußdose 2 eingeführt werden. Es ist auch möglich, daß mehrere elektrische Anschlußkabel 8 durch eine gemeinsame Kabeldurchführöffnung 52 in die Anschlußdose eingeführt werden. Es ist auch möglich, daß lediglich ein elektrisches Anschlußkabel 8 verwendet wird, das zwei oder mehrere elektrische Leiter 22 umfaßt.

Ebenso können zwei oder mehrere Aufnahmeeinrichtungen 34 vorhanden sein und jede der Aufnahmeeinrichtungen 34 eine leiterplattenseitige Öffnung 36 und eine Montageöffnung 38 aufweisen.

Ferner ist es nicht notwendig, daß sich die leiterplattenseitige(n) Öffnung(en) 36 und die Montageöffnung(en) 38 gegenüberliegen. Die Montageöffnung(en) 38 kann/können auch an einer Stirnfläche und/oder einer Seitenfläche der Anschlußdose 2 angeordnet sein.

### Bezugszeichenliste

- 2: Solarpaneel
- 4: Leiterplatte bzw. Solarmodul
- 6: elektrisches Anschlußelement der Leiterplatte
- 8: Anschlußkabel
- 10: Anschlußdose
- 12: Kontaktvorrichtung
- 14: Leiteranschlußelement
- 16: Kurzschlußbereich
- 18: Kontaktelement
- 20: Lötstelle
- 22: elektrischer Leiter des Anschlußkabels 8
- 24: Anschlußkabelbefestigungseinrichtung
- 26: Isolationsmantel
- 28: flexibles Dichtelement
- 30: Gehäusevorrichtung
- 32: Haftmittel
- 34: Aufnahmevorrichtung
- 36: Anschlußeinführöffnung
- 38: Montageöffnung
- 40: Kontaktelementrücken
- 42: Fixierelement
- 44: Gehäusedeckel
- 46: Gehäusedeckeldichtelement
- 48: Nut
- 50: Verriegelungselement
- 52: Kabeldurchführöffnung
- 54: Sollbruchstelle

## Patentansprüche

1. Anschlußdose (10) für eine Leiterplatte (4), insbesondere für ein Solarmodul (4), umfassend:
- zumindest eine Kontaktvorrichtung (12) mit einem Leiteranschlußelement (14) und einem Kontaktelement (18)
- zumindest ein Anschlußkabel (8) mit zumindest einem elektrischen Leiter (22), wobei der elektrische Leiter (22) das Leiteranschlußelement (14) der zumindest einen Kontaktvorrichtung (12) kontaktiert,
- eine Gehäusevorrichtung (30), wobei
- - die Gehäusevorrichtung (30) ausgelegt ist an der Leiterplatte (4) angeordnet zu werden,
- - die Gehäusevorrichtung (30) zumindest eine Aufnahmeeinrichtung (34) mit zumindest zwei Öffnungen aufweist, wobei in der Aufnahmeeinrichtung (34) das Kontaktelement (18) derart angeordnet ist, daß es durch ein elektrisches Anschlußelement (6) der Leiterplatte (4) kontaktierbar ist und mittels zumindest eines Fixierelementes (42) an dem elektrischen Anschlußelement (6) fixierbar ist, und
- zumindest einen Gehäusedeckel (44), der ausgelegt ist zumindest eine Öffnung der Aufnahmevorrichtung (30) im wesentlichen feuchtigkeitsdicht zu schließen,
**dadurch gekennzeichnet, dass** die Anschlussdose
- zumindest ein Dichtelement, welches einen Endbereich des Anschlußkabels umfängt, so daß der Endbereich im wesentlichen feuchtigkeitsdicht ist, aufweist, und dass die Gehäusevorrichtung
- das zumindest eine Dichtelement zumindest in einem Kontaktbereich umfängt und in dem Kontaktbereich die Gehäusevorrichtung derart innig mit dem Dichtelement verbunden ist, daß der Kontaktbereich im wesentlichen feuchtigkeitsdicht ist,
- im wesentlichen flüssig auf das Dichtelement und die Kontaktvorrichtung aufgetragen ist und eine innige Verbindung mit diesen durch Abkühlen und/oder Aushärten der Gehäusevorrichtung erzeugt ist.

2. Anschlußdose (10) nach Anspruch 1, wobei das zumindest eine Dichtelement (28) ein flexibles Dichtelement (28) ist und die Gehäusevorrichtung (30) eine im wesentlichen starre Gehäusevorrichtung (30) ist.

3. Anschlußdose (10) nach Anspruch 1 oder 2, mit zumindest zwei Kontaktvorrichtungen (12) mit jeweils einem Kurzschlußbereich (16), wobei die Kurzschlußbereiche (16) der Kontaktvorrichtungen (12) mittels zumindest einer Bypass-Diode elektrisch verbunden sind und wobei die Kurzschlußbereiche (16) und/oder die zumindest eine Bypass-Diode der Kontaktvorrichtungen (12) zumindest bereichsweise durch das Dichtelement (28) umschlossen sind.

4. Anschlußdose (10) nach einem der vorherigen Ansprüche, wobei das Dichtelement (28) im wesentlichen flüssig auf das Anschlußkabel (8), das Leiteranschlußelement (14), den Kurzschlußbereich (16) und/oder die Bypass-Diode aufgetragen ist und eine innige Verbindung mit diesen durch Abkühlen und/oder Aushärten des Dichtelements (28) erzeugt ist, wobei das Dichtelement (28) vorzugsweise zumindest teilweise mit dem Isoliermantel des Anschlußkabels (8) verschmolzen ist.

5. Anschlußdose (10) nach einem der vorherigen Ansprüche, wobei die Gehäusevorrichtung (30) einstückig ist.

6. Anschlußdose (10) nach einem der vorherigen Ansprüche, wobei die Gehäusevorrichtung (30) zumindest teilweise mit dem Dichtelement (28) verschmolzen ist
und/oder
wobei die Gehäusevorrichtung (30) aus einem Material besteht, das stärker schrumpfbar ist, als das Material des Dichtelements (28).

7. Anschlußdose (10) nach einem der vorherigen Ansprüche, wobei das zumindest eine Fixierelement (42) an dem zumindest einen Gehäusedeckel (44) angeordnet ist, insbesondere das zumindest eine Fixierelement (42) und der zumindest eine Gehäusedeckel (44) einstückig sind.

8. Verwendung einer Anschlußdose (10) gemäß einem der Ansprüche 1 bis 7 und eines Solarmoduls (4) zum Bereitstellen eines Solarpaneels (2), wobei die Anschlußdose an dem Solarmodul angeordnet wird, insbesondere an das Solarmodul geklebt wird.

9. Verwendung einer Anschlußdose (10) gemäß einem der Ansprüche 1 bis 7 zum Verbinden eines Solarmoduls (4) mit einem Leistungsabnehmer, wobei die elektrische Verbindung des Leistungsabnehmers mit dem Solarmodul (4) über die zumindest eine Kontaktvorrichtung (12) der Anschlußdose (10) erfolgt.

10. Verfahren zum Herstellen einer Anschlußdose (10) für eine Leiterplatte (4), insbesondere ein Solarmodul (4), mit den Schritten:
- Bereitstellen zumindest einer Kontaktvorrichtung (12), wobei jede Kontaktvorrichtung (12) ein Kontaktelement (18) und ein Leiteranschlußelement (14) umfaßt,
- Kontaktieren zumindest eines Anschlußkabels (8) mit dem Leiteranschlußelement (14) der zumindest einen Kontaktvorrichtung (12), **dadurch gekennzeichnet, daß** der Verfahren die folgenden Schritten enthält:
- Anordnen eines Dichtelements (28), so daß der Endbereich des Anschlußkabels (8) von dem Dichtelement umfangen wird,
- Ausbilden einer Gehäusevorrichtung (30) umfassend eine Aufnahmevorrichtung (34), so daß das Dichtelement (28) und die Kontaktvorrichtung (12) zumindest bereichsweise von der Gehäusevorrichtung (30) umfangen werden,
- Schrumpfen der Gehäusevorrichtung (30) derart, daß durch das Schrumpfen der Gehäusevorrichtung (30) eine innige Verbindung mit dem zumindest einen Dichtelement (28) und/oder der zumindest einen Kontaktvorrichtung (12) erzeugt wird, so daß eine im wesentlichen feuchtigkeitsdichte Verbindung der Gehäusevorrichtung (30) mit dem Dichtelement (28) und/oder der zumindest einen Kontaktvorrichtung (12) erzeugt wird.

11. Verfahren nach Anspruch 10, mit den weiteren Schritten:
- Anordnen zumindest einer Bypass-Diode an der zumindest einen Kontaktvorrichtung (12);
- Anordnen eines Dichtelements (28), so daß die zumindest eine Bypass-Diode von dem Dichtelement (28) umfangen wird.

12. Verfahren nach einem der Ansprüche 10 oder , wobei zumindest zwei Kontaktvorrichtungen (12) bereitgestellt werden und die zumindest zwei Kontaktvorrichtungen (12) mittels der Bypass-Diode mechanisch und/oder elektrisch miteinander verbunden werden und wobei die zumindest zwei Kontaktvorrichtungen (12) vorzugsweise vor dem Anordnen der zumindest einen Bypass-Diode einteilig sind und wobei die zumindest zwei Kontaktvorrichtungen (12) nach dem Anordnen der Bypass-Diode durch Vereinzelung hergestellt werden.

13. Verfahren nach einem der Ansprüche 10 bis 12, wobei das Dichtelement im wesentlichen flüssig aufgetragen wird und wobei das Verfahren den weiteren Schritt umfaßt:
- Abkühlen und/oder Aushärten des Dichtelements (28).

14. Verfahren zum Herstellen eines Solarpaneels mit den Schritten:
- Bereitstellen einer Anschlußdose gemäß einem der Ansprüche 1 bis 9;
- Aktivieren eines Haftmittels und/oder Dichtmittels an der Anschlußdose (10) und/oder an der Leiterplatte (4)
- Anordnen der Anschlußdose (10) an einer Fläche der Leiterplatte (4) derart, daß
- - zumindest ein elektrisches Anschlußelement (6) der Leiterplatte durch eine Anschlußeinführöffnung (36) in die Aufnahmeeinrichtung (34) eingeführt wird und daß
- - die leiterplattenseitige Öffnung (36) im wesentlichen feuchtigkeitsdicht verschlossen ist,
- Anordnen zumindest eines Fixiermittels (42), so daß das Kontaktelement (18) an dem zumindest einen elektrischen Anschlußelement (6) der Leiterplatte (4) fixiert ist,
- Anordnen eines Gehäusedeckels (44) an der Anschlußdose derart, daß eine Montageöffnung (38) der Aufnahmeeinrichtung (34) mittels des Gehäusedeckels (44) im wesentlichen feuchtigkeitsdicht verschlossen ist.

15. Verfahren nach Anspruch 14, wobei die Fixierung des Kontaktelements an dem zumindest einen elektrischen Anschlußelement (6) der Leiterplatte (4) durch das Schließen des Gehäusedeckels (44) mittels zumindest eines an dem Gehäusedeckel angeordneten Fixiermittels (42) erfolgt.

## Claims

1. A connection box (10) for a conductive panel (4), in particular for a solar module (4), comprising:
- at least one contact device (12) with a conductor connecting element (14) and a contact element (18)
- at least one connecting cable (8) with at least one electrical conductor (22), wherein the electrical conductor (22) contacts the conductor connecting element (14) of the at least one contact device (12),
- a housing device (30), wherein
- the housing device (30) is designed to be arranged on the conductive panel (4),
- the housing device (30) has at least one seat device (34) with at least two openings, wherein the contact element (18) is arranged in the seat device (34) such that it can be contacted by an electrical connecting element (6) of the conductive panel (4), and can be fixed by means of at least one fixing element (42) to the electrical contact element (6), and
- at least one housing cover (44) that is designed to close at least one opening of the seat device (30) substantially moisture-tight,
**characterized in that** the connection box
- has at least one sealing element that surrounds the end area of the connecting cable such that the end area is substantially moisture-tight, and that the housing device
- surrounds the at least one sealing element at least in one contact area, and the housing device is tightly connected in the contact area to the sealing element such that the contact area is substantially moisture-tight,
- is applied substantially liquid to the sealing element and the contact device, and a tight connection thereto by cooling and/or hardening the housing device is created.

2. The connection box (10) according to claim 1, wherein the at least one sealing element (28) is a flexible sealing element (28), and the housing device (30) is a substantially rigid housing device (30).

3. The connection box (10) according to claim 1 or 2, with at least two contact devices (12), each having a short-circuit area (16), wherein the short circuit areas (16) of the contact devices (12) are electrically connected by means of at least one bypass diode, and wherein the short-circuit areas (16) and/or the at least one bypass diode of the contact devices (12) are enclosed at least in sections by the sealing element (28).

4. The connection box (10) according to one of the prior claims, wherein the sealing element (28) is applied substantially liquid to the connecting cable (8), the conductor connecting element (14), the short-circuit area (16) and/or the bypass diode, and a tight connection with them by cooling and/or hardening the sealing element (28) is created, wherein the sealing element (28) is preferably at least partially fused with the insulating sheath of the connecting cable (8).

5. The connection box (10) according to one of the prior claims, wherein the housing device (30) is a single piece.

6. The connection box (10) according to one of the prior claims, wherein the housing device (30) is at least partially fused with the sealing element (28),
and/or
wherein the housing device (30) consists of a material that can shrink more than the material of the sealing element (28).

7. The connection box (10) according to one of the prior claims, wherein the at least one fixing element (42) is arranged on the at least one housing cover (44), in particular the at least one fixing element (42) and the at least one housing cover (44) are a single piece.

8. A use of a connection box (10) according to one of claims 1 to 7 and a solar module (4) to provide a solar panel (2), wherein the connection box is arranged on the solar module, in particular adhered to the solar module.

9. The use of a connection box (10) according to one of claims 1 to 7 for connecting a solar module (4) to a power consumer, wherein the electrical connection of the power consumer to the solar module (4) occurs by means of the at least one contact device (12) of the connection box (10).

10. A method for producing a connection box (10) for a conductive panel (4), in particular a solar module (4), with the steps:
- Providing at least one contact device (12), wherein each contact device (12) comprises a contact element (18) and a conductor connecting element (14),
- Contacting at least one connecting cable (8) with the conductor connecting element (14) of the at least one contact device (12), **characterized in that** the method contains the following steps:
- Arranging a sealing element (28) such that the end area of the connecting cable (8) is surrounded by the sealing element,
- Forming a housing device (30) comprising a seat device (34) such that the sealing element (28) and the contact device (12) are at least sectionally surrounded by the housing device (30),
- Shrinking the housing device (30) such that a tight connection with the at least one sealing element (28) and/or the at least one contact device (12) is created by shrinking the housing device (30) such that a substantially moisture-tight connection is created between the housing device (30) and the sealing element (28) and/or the at least one contact device (12).

11. The method according to claim 10, with the further steps:
- Arranging at least one bypass diode on the at least one contact device (12);
- Arranging a sealing element (28) such that the at least one bypass diode is surrounded by the sealing element (28).

12. The method according to one of claims 10 or , **characterized in that** at least two contact devices (12) are provided, and the at least two contact devices (12) are mechanically and/or electrically connected to each other by means of the bypass diode, and wherein the at least two contact devices (12) are preferably a single piece before arranging the at least one bypass diode, and wherein the at least two contact devices (12) are produced by separation after arranging the bypass diode.

13. The method according to one of claims 10 to 12, wherein the sealing element is applied substantially liquid, and wherein the method comprises the additional step:
- cooling and/or hardening the sealing element (28).

14. The method for producing a solar panel with the steps:
- Providing a connection box according to one of claims 1 to 9;
- Activating an adhesive and/or sealant on the connection box (10) and/or the conductive panel (4)
- Arranging the connection box (10) on a surface of the conductive panel (4) such that
- At least one electrical connecting element (6) of the conductive panel is introduced through a connection insertion opening (36) into the seat device (34), and that
- The conductive-panel-side opening (36) is sealed substantially moisture tight,
- Arranging at least one fixation means (42) such that the contact element (18) is fixed to the at least one electrical connecting element (6) of the conductive panel (4),
- Arranging a housing cover (44) on the connection box such that an installation opening (38) of the seat device (34) is closed substantially moisture-tight by means of the housing cover (44).

15. The method according to claim 14, wherein the contact element is fixed on the at least one electrical connecting element (6) of the conductive panel (4) by closing the housing cover (44) by means of at least one fixing means (42) arranged on the housing cover.

## Revendications

1. Boîte de jonction (10) pour une carte de circuit imprimé (4), en particulier pour un module solaire (4), comprenant :
- au moins un dispositif de contact (12) avec un élément de connexion de conducteur (14) et un élément de contact (18)
- au moins un câble de connexion (8) avec au moins un conducteur électrique (22), le conducteur électrique (22) réalisant le contact avec l'élément de connexion de conducteur (14) du dispositif de contact (12) au moins au nombre de un,
- un dispositif de boîtier (30),
- - le dispositif de boîtier (30) étant conçu pour être disposé sur la carte de circuit imprimé (4),
- - le dispositif de boîtier (30) présentant au moins un dispositif de réception (34) avec au moins deux ouvertures, l'élément de contact (18) étant disposé dans le dispositif de réception (34) de telle sorte qu'il peut être mis en contact par un élément de connexion électrique (6) de la carte de circuit imprimé (4) et peut être fixé sur l'élément de connexion électrique (6) au moyen d'au moins un élément de fixation (42), et
- au moins un couvercle de boîtier (44) qui est conçu pour fermer au moins une ouverture du dispositif de réception (30) d'une façon essentiellement étanche à l'humidité,
**caractérisée en ce que** la boîte de jonction
- présente au moins un élément d'étanchéité qui entoure une zone d'extrémité du câble de connexion de telle sorte que la zone d'extrémité est essentiellement étanche à l'humidité, et **en ce que** le dispositif de boîtier
- entoure l'élément d'étanchéité au moins au nombre de un au moins dans une zone de contact, et **en ce que** le dispositif de boîtier est, dans la zone de contact, raccordé étroitement à l'élément d'étanchéité de telle sorte que la zone de contact est essentiellement étanche à l'humidité,
- est appliqué de façon essentiellement liquide sur l'élément d'étanchéité et le dispositif de contact, et un raccordement étroit avec ceux-ci est produit par le refroidissement et/ou le durcissement du dispositif de boîtier.

2. Boîte de jonction (10) selon la revendication 1, l'élément d'étanchéité (28) au moins au nombre de un étant un élément d'étanchéité (28) flexible, et le dispositif de boîtier (30) étant un dispositif de boîtier (30) essentiellement rigide.

3. Boîte de jonction (10) selon la revendication 1 ou 2, avec au moins deux dispositifs de contact (12) avec respectivement une zone de court-circuit (16), les zones de court-circuit (16) des dispositifs de contact (12) étant raccordées électriquement au moyen d'au moins une diode by-pass, et les zones de court-circuit (16) et/ou la diode by-pass au moins au nombre de un des dispositifs de contact (12) étant entourées au moins par tronçons par l'élément d'étanchéité (28).

4. Boîte de jonction (10) selon une des revendications précédentes, l'élément d'étanchéité (28) étant appliqué essentiellement de façon liquide sur le câble de connexion (8), l'élément de connexion de conducteur (14), la zone de court-circuit (16) et/ou la diode by-pass, et un raccordement étroit avec ces éléments étant produit par le refroidissement et/ou le durcissement de l'élément d'étanchéité (28), l'élément d'étanchéité (28) étant de préférence fusionné au moins partiellement avec la gaine isolante du câble de connexion (8).

5. Boîte de jonction (10) selon une des revendications précédentes, le dispositif de boîtier (30) étant d'une seule pièce.

6. Boîte de jonction (10) selon une des revendications précédentes, le dispositif de boîtier (30) étant fusionné au moins partiellement avec l'élément d'étanchéité (28) et/ou
le dispositif de boîtier (30) étant constitué d'un matériau qui est plus fortement rétractable que le matériau de l'élément d'étanchéité (28).

7. Boîte de jonction (10) selon une des revendications précédentes, l'élément de fixation (42) au moins au nombre de un étant disposé sur le couvercle de boîtier (44) au moins au nombre de un, l'élément de fixation (42) au moins au nombre de un et le couvercle de boîtier (44) au moins au nombre de un étant en particulier d'une seule pièce.

8. Utilisation d'une boîte de jonction (10) selon une des revendications 1 à 7 et d'un module solaire (4) pour la réalisation d'un panneau solaire (2), la boîte de jonction étant disposée sur le module solaire, étant en particulier collée sur le module solaire.

9. Utilisation d'une boîte de jonction (10) selon une des revendications 1 à 7 pour le raccordement d'un module solaire (4) à un consommateur de puissance, le raccordement électrique du consommateur de puissance au module solaire (4) s'effectuant par le biais du dispositif de contact (12) au moins au nombre de un de la boîte de jonction (10).

10. Procédé de fabrication d'une boîte de jonction (10) pour une carte de circuit imprimé (4), en particulier un module solaire (4), comportant les étapes suivantes :
- fourniture d'au moins un dispositif de contact (12), chaque dispositif de contact (12) comprenant un élément de contact (18) et un élément de connexion de conducteur (14),
- mise en contact d'au moins un câble de connexion (8) avec l'élément de connexion de conducteur (14) du dispositif de contact (12) au moins au nombre de un,
**caractérisé en ce que** le procédé comporte les étapes suivantes :
- disposition d'un élément d'étanchéité (28) de telle sorte que la zone d'extrémité du câble de connexion (8) est entourée de l'élément d'étanchéité,
- constitution d'un dispositif de boîtier (30) comprenant un dispositif de réception (34) de telle sorte que l'élément d'étanchéité (28) et le dispositif de contact (12) sont entourés au moins par tronçons du dispositif de boîtier (30),
- retrait du dispositif de boîtier (30) de telle sorte que, sous l'action du retrait du dispositif de boîtier (30), il se produit un raccordement étroit avec l'élément d'étanchéité (28) au moins au nombre de un et/ou avec le dispositif de contact (12) au moins au nombre de un de telle sorte qu'il se produit un raccordement essentiellement étanche à l'humidité du dispositif de boîtier (30) avec l'élément d'étanchéité (28) et/ou avec le dispositif de contact (12) au moins au nombre de un.

11. Procédé selon la revendication 10, avec les étapes supplémentaires :
- disposition d'au moins une diode by-pass sur le dispositif de contact (12) au moins au nombre de un ;
- disposition d'un élément d'étanchéité (28) de telle sorte que la diode by-pass au moins au nombre de un est entourée de l'élément d'étanchéité (28).

12. Procédé selon une des revendications 10 ou , au moins deux dispositifs de contact (12) étant fournis, et les dispositifs de contact (12) au moins au nombre de deux étant raccordés l'un à l'autre mécaniquement et/ou électriquement au moyen de la diode by-pass, et les dispositifs de contact (12) au moins au nombre de deux étant de préférence d'un seul tenant avant la disposition de la diode by-pass au moins au nombre de un, et les dispositifs de contact (12) au moins au nombre de deux étant, après la disposition de la diode by-pass, fabriqués par séparation.

13. Procédé selon une des revendications 10 à 12, l'élément d'étanchéité étant appliqué essentiellement de façon liquide, et le procédé comprenant l'étape supplémentaire suivante :
- refroidissement et/ou durcissement de l'élément d'étanchéité (28).

14. Procédé de fabrication d'un panneau solaire, avec les étapes suivantes :
- fourniture d'une boîte de jonction selon une des revendications 1 à 9 ;
- activation d'un adhésif et/ou d'un moyen d'étanchéité sur la boîte de jonction (10) et/ou sur la carte de circuit imprimé (4)
- disposition de la boîte de jonction (10) sur une surface de la carte de circuit imprimé (4) de telle sorte que
- - au moins un élément de connexion électrique (6) de la carte de circuit imprimé est introduit à travers une ouverture d'introduction de connexion (36) dans le dispositif de réception (34), et en ce que
- - l'ouverture (36) côté carte de circuit imprimé est obturée d'une façon essentiellement étanche à l'humidité,
- disposition d'au moins un moyen de fixation (42) de telle sorte que l'élément de contact (18) est fixé sur l'élément de connexion électrique (6) au moins au nombre de un de la carte de circuit imprimé (4),
- disposition d'un couvercle de boîtier (44) sur la boîte de jonction de telle sorte qu'une ouverture de montage (38) du dispositif de réception (34) est obturée au moyen du couvercle de boîtier (44) d'une façon essentiellement étanche à l'humidité.

15. Procédé selon la revendication 14, la fixation de l'élément de contact sur l'élément de connexion électrique (6) au moins au nombre de un de la carte de circuit imprimé (4) s'effectuant par la fermeture du couvercle de boîtier (44) au moyen d'au moins un moyen de fixation (42) disposé sur le couvercle de boîtier.
